# EUROPEAN PATENT APPLICATION

(11) **EP 4 451 352 A1**
(43) Date of publication of application: **23.10.2024**
(21) Application number: 23746170.2
(22) Date of filing: 18.01.2023
(51) Int. Cl.: H01L 31/18, H01L 31/0224, H01L 31/048

(54) **PHOTOVOLTAIC ASSEMBLY PREPARATION METHOD, PHOTOVOLTAIC ASSEMBLY, AND HETEROJUNCTION CELL**

(30) Priority: 25.01.2022 CN 202210085775; 25.01.2022 CN 202220208702 U; 25.01.2022 CN 202220208694 U
(71) Applicant: CSI Solar Technologies (Jiaxing) Co., Ltd., Jiaxing, Zhejiang 314001 (CN)
(72) Inventor: ZHANG, Daqi, Jiaxing, Zhejiang 314001 (CN); WU, Jian, Jiaxing, Zhejiang 314001 (CN); JIANG, Fangdan, Jiaxing, Zhejiang 314001 (CN)
(74) Representative: Murgitroyd & Company
(86) International application number: PCT/CN2023/072811
(87) International publication number: WO 2023/143288

(57) **Abstract**

A method for preparing a photovoltaic assembly, a photovoltaic assembly and a heterojunction cell are disclosed. The method for preparing the photovoltaic assembly includes: preparing a plurality of cell chips; forming a cell string, including connecting the plurality of cell chips by an electrical connector to form the cell string; and irradiating the plurality of cell chips with light, including irradiating the plurality of cell chips with light having a wavelength in a range of 200nm to 500 nm.

## Description

### TECHNICAL FIELD

The present disclosure relates to the technical field of photovoltaic assemblies, and more particularly, to a method for preparing a photovoltaic assembly, a photovoltaic assembly and a heterojunction cell.

### BACKGROUND

In the related technology, during preparation of a cell chip, organic components of a slurry are prone to volatilize onto a surface of the cell chip in a low-temperature drying and curing process, resulting in a decrease in the surface energy of the cell chip. The decrease in the surface energy of the cell chip results in a decrease in a peeling energy between the cell chip and an encapsulating adhesive film layer, resulting in a risk of a reliability failure, especially in the outdoors where the cell chip is affected by illumination, temperature changes, humidity and so on.

### SUMMARY

The present disclosure aims to solve at least one of the technical problems existing in the prior art. Therefore, a first purpose of the present disclosure is to propose a method for preparing a photovoltaic assembly, which can remove organic dirt from a surface of a cell chip, including flux residues brought by the cell chip during the preparation process and flux residues of the photovoltaic assembly, so that the peeling energy between the cell chip and the encapsulating adhesive film layer can be improved, the power of the photovoltaic assembly can be enhanced, and the reliability of the photovoltaic assembly can be improved.

A second purpose of the present disclosure is to propose a photovoltaic assembly obtained by the method for preparing a photovoltaic assembly as described above.

A third purpose of the present disclosure is to propose a heterojunction cell, the photovoltaic assembly includes the heterojunction cell.

A method for preparing a photovoltaic assembly according to an embodiment in a first aspect of the present disclosure includes the following steps:
preparing a plurality of cell chips;
forming a cell string, including connecting the plurality of cell chips by an electrical connector to form the cell string; and
irradiating the plurality of cell chips with light, including irradiating the plurality of cell chips with light having a wavelength in a range of 200nm to 500 nm.

According to the method for preparing the photovoltaic assembly of the present disclosure, the plurality of cell chips are irradiated with light in a wavelength range of 200nm to 500nm, and after irradiation with light in a wavelength range of 200nm to 500nm, organic dirt on the surface of the cell chips can be removed, including the flux residues brought by the cell chip during the preparation process and flux residues of the photovoltaic assembly, so that the peeling energy between the cell chip and an encapsulating adhesive film layer can be enhanced, the power of the photovoltaic assembly can be enhanced, and the reliability of the photovoltaic assembly can be improved.

In some examples of the present disclosure, before the step of forming the cell string, the plurality of cell chips are irradiated using light having a wavelength in a range of 200nm to 500 nm.

In some examples of the present disclosure, the step of preparing the plurality of cell chips includes: performing cutting using a slicing machine to form the plurality of cell chips. The step of irradiating the plurality of cell chips with light includes: irradiating the plurality of cell chips with light having a wavelength in the range of 200nm to 500 nm on a transfer track located behind the slicing machine. And/or, the method further includes: after the step of preparing the plurality of cell chips and before the step of irradiating the plurality of cell chips with light, or after the step of irradiating the plurality of cell chips with light and before the step of forming the cell string, stacking the plurality of cell chips up and loading the plurality of cell chips that are stacked up onto a series welding machine.

In some examples of the present disclosure, the step of irradiating the plurality of cell chips with light further includes: after the step of forming the cell string, irradiating the cell string with light having a wavelength in the range of 200nm to 500nm.

In some examples of the present disclosure, after the step of forming the cell string, the cell string is irradiated by light having a wavelength in a range of 200nm to 500 nm.

In some examples of the present disclosure, the step of irradiating the plurality of cell chips with light includes: irradiating the plurality of the cell chips or the cell string using UV light.

In some examples of the present disclosure, the step of irradiating the plurality of cell chips with light includes: irradiating the plurality of cell chips or the cell string using a UV light combination; or irradiating the plurality of cell chips or the cell string using UVC of different wavelengths.

In some examples of the present disclosure, the step of irradiating the plurality of cell chips with light includes: irradiating the plurality of cell chips or the cell string with UVC that has a first wavelength and a radiation intensity in a range of 5W/m² to 30W/m² and UVC that has a second wavelength and a radiation intensity in a range of 100W/m² to 500W/m², the first wavelength is less than the second wavelength.

In some examples of the present disclosure, in the step of irradiating the plurality of cell chips with light, an irradiation duration is t, t satisfying: 1min≤t≤20min; and/or; an ambient temperature is T, T satisfying: 20°C ≤ T ≤ 120°C.

A photovoltaic assembly according to an embodiment in a second aspect of the present disclosure is prepared using the method for preparing a photovoltaic assembly as described in any one of the above examples.

In some examples of the present disclosure, the photovoltaic assembly includes: a cover plate; an encapsulating adhesive film layer; and a heterojunction cell. The encapsulating adhesive film layer is provided between the heterojunction cell and the cover plate, and a peeling energy value between the heterojunction cell and the encapsulating adhesive film layer is greater than or equal to 200J/m².

In some examples of the present disclosure, the peeling energy value between the heterojunction cell and the encapsulating adhesive film layer is greater than or equal to 400J/m².

In some examples of the present disclosure, the heterojunction cell includes: a cell body; a transparent conductive film layer provided on the cell body; and a metal electrode. The metal electrode is provided on a surface of the transparent conductive film layer that faces away from the cell body. The encapsulating adhesive film layer is provided on a surface of the metal electrode that faces away from the cell body.

In some examples of the present disclosure, the cover plate includes a first cover plate and a second cover plate, The encapsulating adhesive film layer includes a first encapsulating adhesive film layer and a second encapsulating adhesive film layer. The first encapsulating adhesive film layer is disposed between the first cover plate and the heterojunction cell, and the second encapsulating adhesive film layer is disposed between the second cover plate and the heterojunction cell. The peeling energy value between the heterojunction cell and the first encapsulating adhesive film layer is greater than or equal to 200 J/m².

In some examples of the present disclosure, the cell body has a light-receiving surface and a backlighting surface, the transparent conductive film layer includes a first transparent conductive film layer and a second transparent conductive film layer. The first transparent conductive film layer is disposed on the light-receiving surface, and the second transparent conductive film layer is disposed on the backlighting surface. The peeling energy value between a surface of the first transparent conductive film layer and the first encapsulating adhesive film layer is greater than or equal to 200 J/m²; and/or the peeling energy value between a surface of the second transparent conductive film layer and the second encapsulating adhesive film layer is greater than or equal to 200 J/m².

In some examples of the present disclosure, the cell body includes a silicon substrate and an amorphous silicon layer. The amorphous silicon layer is disposed on a surface of the silicon substrate, the transparent conductive film layer is disposed on a surface of the amorphous silicon layer, the surface of the silicon substrate is a textured surface, and the textured surface has an average size of less than 2µm.

A heterojunction cell according to an embodiment in a third aspect of the present disclosure includes: a cell body; a transparent conductive film layer and a metal electrode. The transparent conductive film layer is disposed on the cell body. A surface at one side of the transparent conductive film layer that faces away from the cell body is an electrode fixing surface. The electrode fixing surface has a surface energy value that is greater than or equal to 40 mN/m and that is less than or equal to 80 mN/m. The metal electrode is provided on the electrode fixing surface.

In some examples of the present disclosure, the cell body has a light-receiving surface and a backlighting surface. The transparent conductive film layer includes a first transparent conductive film layer and a second transparent conductive film layer. The first transparent conductive film layer is disposed on the light-receiving surface, and the second transparent conductive film layer is disposed on the backlighting surface. A surface at one side of the first transparent conductive film layer that faces away from the light-receiving surface is a first electrode fixing surface, and a surface at one side of the second transparent conductive film layer that faces away from the backlighting surface is a second electrode fixing surface. The first electrode fixing surface has a surface energy value greater than or equal to 40 mN/m; and/or the second electrode fixing surface has a surface energy value greater than or equal to 40mN/m.

The additional aspects and advantages of the present disclosure will be partially provided in the following description, and will partially become apparent from the following description or will be learned through the practice of this application.

### BRIEF DESCRIPTION OF DRAWINGS

The above and/or additional aspects and advantages of the present disclosure will become apparent and easy to understand from the description of embodiments in conjunction with the accompanying drawings, in which:
FIG. 1 is an overall flow chart of a method for preparing a photovoltaic assembly according to an embodiment of the present disclosure;
FIG. 2 is a flowchart of a first example of a method for preparing a photovoltaic assembly according to an embodiment of the present disclosure;
FIG. 3 is a flowchart of a first example of a method for preparing a photovoltaic assembly in a first situation according to an embodiment of the present disclosure;
FIG. 4 is a flowchart of a first example of a method for preparing a photovoltaic assembly in a second situation according to an embodiment of the present disclosure;
FIG. 5 is a flowchart of a second example of a method for preparing a photovoltaic assembly according to an embodiment of the present disclosure;
FIG. 6 is a schematic diagram of a photovoltaic assembly according to an embodiment of the present disclosure;
FIG. 7 is a schematic diagram of a heterojunction cell according to an embodiment of the present disclosure.

### Reference numerals:

100: Photovoltaic assembly;
10: Cover plate; 11: First cover plate; 12: Second cover plate;
20: Encapsulating adhesive film layer; 21: First encapsulating adhesive film layer; 22: Second encapsulating adhesive film layer;
30: heterojunction cell; 31: cell body; 310: Light-receiving surface; 311: Backlighting surface; 312: Silicon substrate; 313: Amorphous silicon layer; 32: Transparent conductive film layer; 320: First transparent conductive film layer; 321: Second transparent conductive film layer; 33: Metal electrode; 34: Electrode fixing surface; 341: First electrode fixing surface; 342: Second electrode fixing surface.

### DESCRIPTION OF EMBODIMENTS

Embodiments of the present disclosure will be described in detail below, and examples of the embodiments are shown in the accompanying drawings in which the same reference numeral or similar reference numerals throughout the description denote(s) a same element or similar elements or elements having the same or similar functions. The embodiments described below with reference to the accompanying drawings are illustrative, and are used only to explain the present disclosure and can not be understood as a limitation to the present disclosure.

Embodiments of the present disclosure will be described in detail below, and the embodiments described with reference to the accompanying drawings are exemplary. Embodiments of the present disclosure will be described in detail below.

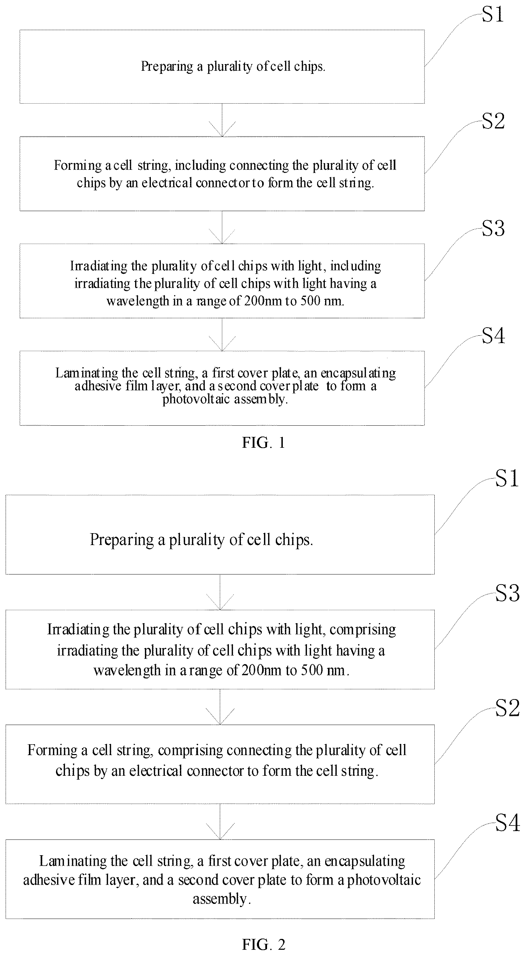

A method for preparing a photovoltaic assembly 100 according to embodiments of the present disclosure, and the photovoltaic assembly 100 prepared by the method are described below with reference to FIG. 1 to FIG. 7.

As shown in FIG. 1, the method for preparing a photovoltaic assembly 100 according to an embodiment of the present disclosure includes the following steps.

At S 1, a plurality of cell chips are prepared. Specifically, in the preparation method of the cell chips, the plurality of cell chips can be prepared by texturing, chemical vapor deposition (CVD), physical vapor deposition (PVD), screen printing, low-temperature drying, curing, photo-thermal processing, and testing and sorting.

At S2, a cell string is formed, including connecting the plurality of cell chips by an electrical connector to form the cell string. The plurality of cell chips may form a cell string through the electrical connector, so that the plurality of cell chips can be connected as a whole, which facilitates the installation and setup of the plurality of cell chips, and at the same time, facilitates electric conduction of the plurality of cell chips. The electrical connector can be a metal wire or a metal film, such as a welding tape, or a conductive metal wire film interconnector. The electrical connector is mainly to connect the anodic and cathodic of the neighboring cell chips sequentially to form the cell string, and the process of forming the cell string from the plurality of cell chips can be called series welding. In addition, in actual use, series welding is performed by loading a whole sheet of material onto an all-in-one machine having slicing and series welding functions, slicing the whole sheet through the all-in-one machine, and then welding the material sheets that are obtained after the slicing. Alternatively, the series welding can be performed by an offline slicing machine and a series welding machine (the slicing machine and the series welding machine being generally in the same workshop at the same time), in this case the sheet is sliced first and then is transported to the series welding machine and is subject to the series welding.

At S3, the plurality of cell chips are irradiated with light, including irradiating the plurality of cell chips with light having a wavelength in a range of 200nm to 500nm. The plurality of cell chips are irradiated by light with a wavelength in a range of 200nm to 500nm. After the cell chip is irradiated by light with a wavelength in a range of 200nm to 500nm, the organic dirts on the surface of the cell chip can be removed, for example, flux residues brought by the cell chip during the preparation process and flux residues of the photovoltaic assembly 100 after the cell chip is irradiated by light, so as to improve the peeling energy between the cell chip and the encapsulating adhesive film layer 20, improve the power of the photovoltaic assembly 100, and improve the reliability of the photovoltaic assembly 100. It is noted that step S3 may be performed before or after step S2.

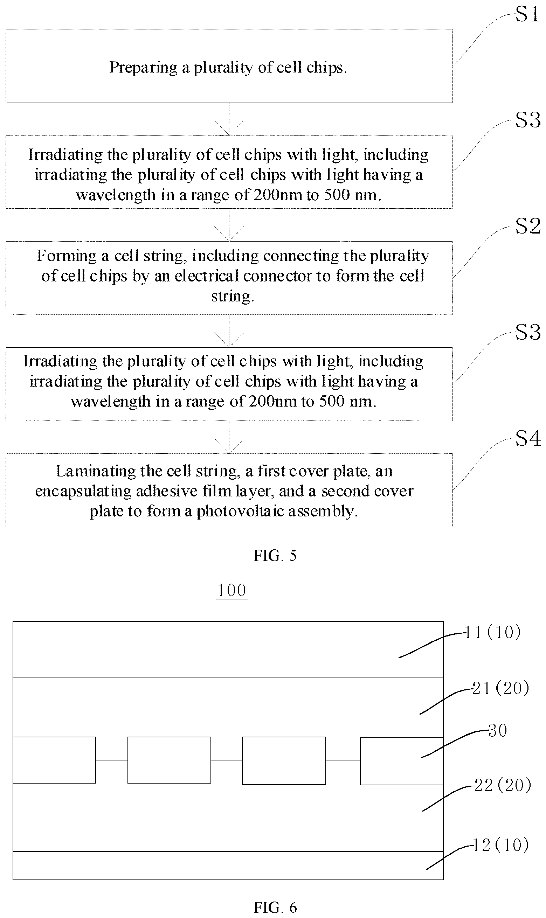

At S4, the cell string, a first cover plate 11, an encapsulating adhesive film layer 20, and a second cover plate 12 are laminated to form the photovoltaic assembly 100. As shown in FIG. 6, after passing through the first cover plate 11 and the encapsulating adhesive film layer 20, the sunlight reaches the cell string to conduct electricity and reaches the encapsulating adhesive film layer 20 on the other side of the cell string through the gaps in the cell string, and then passes through the encapsulating adhesive film layer 20 to reach the second cover plate 12. The second cover plate 12 reflects the sunlight, and the reflected sunlight passes through the encapsulating adhesive film layer 20 on the other side of the cell string to re-irradiate the cell string, so that the conversion efficiency of the cell string can be increased.

As shown in FIG. 2, the plurality of cell chips are irradiated with light having a wavelength in a range of 200nm to 500nm before the step S2. That is, the step S3 is set before the step S2. In this way, organic matters on the surface of grid lines of the cell chip can be removed before a welding tape is welded to the cell chip, so as to improve the pulling-out force of the welding tape and to ensure the reliability of the connection between the welding tape and the cell chip.

Optionally, in the step S1, a slicing machine is used to perform cutting operations so as to obtain the plurality of cell chips. That is, when the slicing machine is an online slicing machine, the plurality of cell chips can be obtained by the cutting operations of the online slicing machine, and then can be transferred directly to a next procedure after the cutting process is completed.

In the step S3, the plurality of cell chips are irradiated with light having a wavelength in a range of 200nm to 500nm on a transfer track located behind the slicing machine. That is, after cutting operations of the online slicing machine are performed to obtain the plurality of cell chips, the plurality of cell chips can be transferred to a series welding procedure via the transfer track. Before the series welding, the plurality of cell chips can be irradiated by light with a wavelength in a range of 200nm to 500nm on the transfer track, so that organic matters on the surfaces of the grid lines of the cell chips can be removed before the welding tapes are welded to the cell chips. In this way, the pulling-out force of the welding tape can be improved and the reliability of the connection between the welding tape and the cell chip can be ensured.

Optionally, in the step S1, a slicing machine is used to perform cutting so as to obtain the plurality of cell chips. That is, when the slicing machine is an offline slicing machine, the plurality of cell chips can be obtained by the cutting operations of the offline slicing machine, and then the plurality of cell chips that have been subject to the cutting operation can be carried onto the series welding machine for series welding and other processes, so that the cell chips can be prepared in this way.

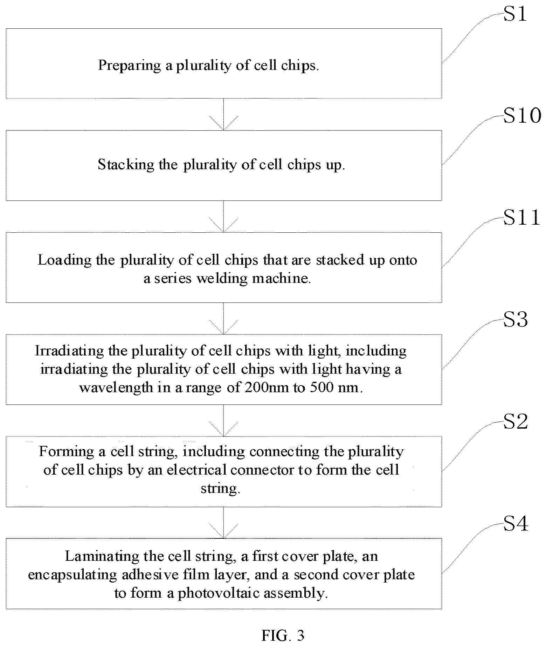

As shown in FIG. 3, after the step S1 and before the step S3, the following steps are included:

At S10, the plurality of cell chips are stacked up. As the cut plurality of cell chips need to be carried to the series welding machine, the plurality of cell chips are stacked up. In this way, it is more convenient to carry the plurality of cell chips to the series welding machine.

At S11, the plurality of cell chips that are stacked up are loaded onto a series welding machine. After the plurality of cell chips are carried to the series welding machine, the plurality of cell chips also need to be loaded onto the series welding machine, so that the plurality of cell chips can be subject to series welding in a better way.

That is, the plurality of cell chips can be stacked up before using the light with a wavelength in the range of 200nm to 500nm to irradiate the plurality of cell chips, and the plurality of cell chips that are stacked up are loaded onto the series welding machine. In this way, it can avoid generating dirts after the plurality of cell chips are stacked up, which would otherwise affect the effect of light irradiation in the wavelength range of 200nm to 500nm. In addition, since the stacked cell chips possibly may not be subject to series welding in time, which causes that the surface energy will decrease during the arranging process, it is preferred that a UV treatment be performed after the cell chip is loaded onto the series welding machine.

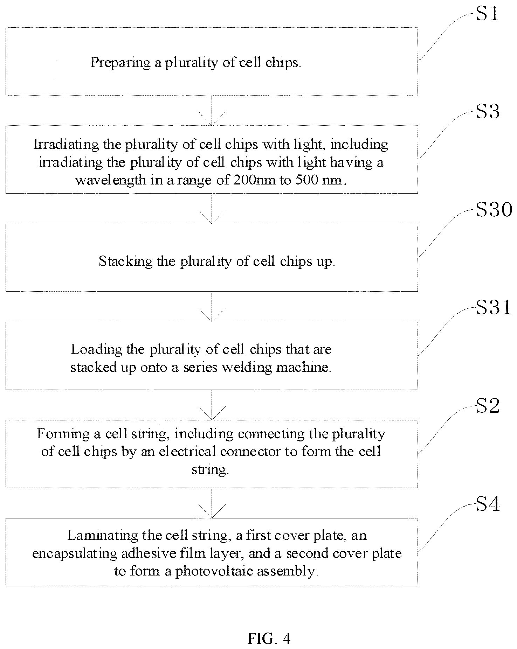

Alternatively, as shown in FIG. 4, the following steps may be included after the step S3 and before the step S2:

At S30, the plurality of cell chips are stacked up. Similarly, as the cut plurality of cell chips need to be carried to the series welding machine, the plurality of cell chips are stacked up. In this way, it is more convenient to carry the plurality of cell chips to the series welding machine.

At S31, the plurality of cell chips that are stacked up are loaded onto a series welding machine. Similarly, after the plurality of cell chips are carried to the series welding machine, the plurality of cell chips also need to be loaded onto the series welding machine, so that the plurality of cell chips can be subject to series welding in a better way.

In other words, it is possible to stack up the plurality of cell chips after irradiating the plurality of cell chips with light having a wavelength in a range of 200nm to 500nm, as well as to load the stacked plurality of cell chips onto the series welding machine. In this way, it can avoid irradiating the plurality of cell chips with light having a wavelength in a range of 200nm to 500nm on the series welding machine, which would otherwise cause inconvenience to the series welding of the plurality of cell chips.

In addition, as shown in FIG. 5, the step S3 further includes: after the step S2, irradiating the cell string with light having a wavelength in the range of 200nm to 500nm. In other words, not only the string of cell chips are irradiated with light in the wavelength range of 200nm to 500nm before the step S2, but also the string of cell chips are irradiated with light in the wavelength range of 200nm to 500nm after the plurality of cell chips are connected by means of the electrical connector to form the string of cell chips. This enhances the peeling energy between the cell chip and the encapsulating adhesive film layer 20, removes the flux residues on the surface of the cell chip, reduces the corrosion of the flux on the cell chip and the encapsulating adhesive film layer 20 during the lamination process, and enhances the initial efficiency and reliability of the photovoltaic assembly 100.

Of course, as shown in FIG. 1, after the step S2, the cell string is irradiated with light having a wavelength in a range of 200nm to 500nm. In other words, the step S2 is set before the step S3. In this way, the flux residues on the surface of the cell chip can be removed, the corrosion of the flux on the cell chip and the encapsulating adhesive film layer 20 during the lamination process can be reduced, and the initial efficiency and reliability of the photovoltaic assembly 100 can be improved.

In addition to this, the step S3 includes: irradiating the plurality of the cell chips or the cell string using ultraviolet (UV) light. Using UV light to irradiate the surface of the plurality of cell chips or cell string can better improve the surface energy value of the irradiated surface of the plurality of cell chips or cell string. Preferably, the UV irradiation can be performed in combination with a string EL (expression language) detection station.

The following is a detailed description of a test method the cell chip surface energy .

Liquids with different surface energy values are selected to be respectively applied onto the surfaces of the cell chips via brush coating. The expansion or contraction of the liquids within 5 seconds is observed. If the surface energy of the cell chip is less than or equal to the surface energy value of the liquid, the ink does not expand or contract. If the surface energy of the cell chip is greater than the surface energy value of the liquid, the ink expands. The upper limit of the surface energy of the test liquid is 72mN/m. The cell chip is firstly unpacked, then enters the transfer track, and then is subject to UV irradiation. Then, a welding tape attached with flux is arranged on the surface of the cell chip, heating and welding are performed, and the cell string is subject to layout and lamination.

In a first example of the method for preparing the photovoltaic assembly 100, in the experimental group 1, a UV irradiation step in the first example is performed, i.e., the to-be-irradiated surface of the cell chip is irradiated by UV with 150W/m² at 130°C for 1 min; in the comparative group 1, a UV irradiation step is not performed. The comparative data in Table 1 shows that, after adding the UV irradiation according to the procedure of the first example, the surface energy of the irradiated surface of the cell chip is enhanced from 34mN/m to 72mN/m, and the peeling energy between the irradiated surface of the cell chip and the encapsulating adhesive film layer 20 is enhanced from 430J/m² to 660J/m², and at the same time, the pulling-out force of the welding tape can be enhanced from 0.84N to 1.05N due to removal of the organic matters on the surface of the grid line of the cell chip before welding the welding tape, as shown in Table 1.

**Table 1 Performance improvement of the cell chip and the photovoltaic assembly 100 caused by different post-treatments**

| Sample | The surface energy of the irradiated surface of the cell chip (mN/m) | The peeling energy between the irradiated surface of the cell chip and the encapsulating adhesive film layer 20 (J/m²) | The pulling-out force of the welding tape (N) |
|---|---|---|---|
| Comparative group 1 | 34 | 430 | 0.84 |
| Experimental group 1 | 72 | 660 | 1.05 |

In a third example of the method for preparing the photovoltaic assembly 100, in the experimental group 2, a UV irradiation step in the third example is performed, i.e., the to-be-irradiated surface of the cell chip is irradiated by UV with 150W/m² at 130°C for 1 min; in the comparative group 2, a UV irradiation step is not performed. The comparative data in Table 2 shows that, after adding the UV irradiation according to the procedure of the third example, the surface energy of the irradiated surface of the cell chip is increased from 34mN/m to 72mN/m, and the peeling energy between the irradiated surface of the cell chip and the encapsulating adhesive film layer 20 is increased from 430J/m² to 700J/m², and at the same time, the influence of flux on the cell chip during lamination is reduced due to the removal of the flux residues on the surface of the cell chip. The initial efficiency of the photovoltaic assembly 100 is increased from 21.70% to 21.75%, and the relative attenuation amplitude of power of the photovoltaic assembly 100 is reduced from 2.2% to 1.4% after DH1000 (85°C, relative humidity of 85%, 1000h), as shown in Table 2.

**Table 2 Performance improvement of cell chip and the photovoltaic assembly 100 caused by different post-treatments**

| Sample | The surface energy of the irradiated surface of the cell chip (mN/m) | The peeling energy between the irradiated surface of the cell chip and the encapsulating adhesive film layer 20(J/m²) | Efficiency of the photovoltaic assembly 100 | Relative power attenuation amplitude of photovoltaic assembly 100 power after DH1000 |
|---|---|---|---|---|
| Comparative group 2 | 34 | 430 | 21.70% | 2.2% |
| Experimental group 2 | 72 | 700 | 21.75% | 1.4% |

In a second example of the method for preparing the photovoltaic assembly 100, the first example and the third example can be combined so that the effects in the first example and the third example can be merged.

According to an optional example of the present disclosure, the step S3 includes: irradiating the plurality of cell chips or the cell string using a UV light combination. That is, the surface of the cell chips or the cell string is irradiated by the UV light in different combinations. In this way, the organic dirt on the surface of the cell chips or the cell string can be removed, and different effects are realized, so that it can cope wit demands in different situations.

Optionally, the step S3 includes: irradiating the plurality of cell chips or the cell string using UVC (short-wave ultraviolet light) of different wavelengths. After irradiating the surface of the cell chip or the cell string with UVC of different wavelengths, the organic dirt on the surface of the cell chip or the cell string can also be effectively removed under certain circumstances, and the surface energy of the cell chip or the cell string can be enhanced, so as to effectively improve the peeling energy between the cell chip and the encapsulating adhesive film layer 20, and enhance the reliability of the connection between the encapsulating adhesive film layer 20 and the cell chip.

Specifically, the step S3 includes: irradiating the plurality of cell chips or the cell string with UVC that has a first wavelength and a radiation intensity in a range of 5W/m² to 30W/m² and UVC that has a second wavelength and a radiation intensity in a range of 100W/m² to 500W/m², the first wavelength is less than the second wavelength. That is to say, the radiation intensity range of the UVC with a smaller wavelength is set to 5W/m²-30W/m², and the radiation intensity range of the UVC with a larger wavelength is set to 100W/m²-500W/m². This design is more reasonable, and can better meet the requirement of UVC with different wavelengths for the radiation of the surface of the cell chip or the cell string. Therefore, the irradiation effect using UVC of different wavelengths is better, and it can prevent a too small radiation intensity which will cause an effect of removing organic dirt on the surface of the cell chip or the cell string being poor, and can prevent a too large radiation which may lead to a negative effect on the overall structure and performance of the cell chip or the cell string. Herein, the first wavelength is preferably 185nm and the second wavelength is preferably 254nm.

In addition, in the step S3, an irradiation duration is t, and t satisfies a relationship of 1min≤t≤20min. That is to say, the irradiation duration using UVC of different wavelengths needs to meet a certain condition, and the irradiation duration is preferably in the range of 1min-20min. Similarly, this can make the irradiation effect of UVC with the different wavelengths better, prevent a too short irradiation duration which will cause the effect of removing organic dirt on the surface of the cell chip being poor, and prevent a too long irradiation duration which may lead to a negative effect on the overall structure and performance of the cell chip.

Of course, in the step S3, an ambient temperature is T, and T satisfies a relationship of 20°C ≤ T ≤ 120°C. The ambient temperature needs to be greater than or equal to 20° C. When the UVC of different wavelengths irradiates the surface of the cell chip, the structure of the cell chip will be damaged if the ambient temperature is too high. Therefore, the ambient temperature needs to be less than or equal to 120° C, which can causes the UVC of different wavelengths to better act on the surface of the cell chip, so as to better remove the organic dirt on the surface of the heterojunction cell 30.

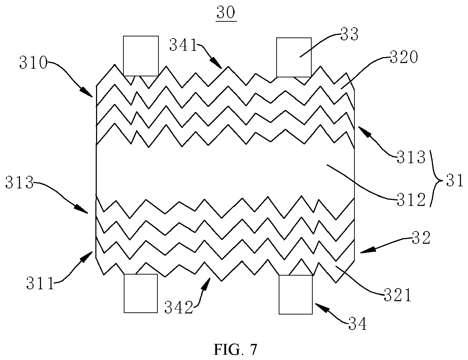

As shown in FIGS. 6 and 7, a photovoltaic assembly 100 according to an embodiment in a second aspect of the present disclosure is prepared using the method for preparing a photovoltaic assembly 100 described in any of the above embodiments. The photovoltaic assembly 100 includes a cover plate 10, an encapsulating adhesive film layer 20, and a heterojunction cell 30. The heterojunction cell 30 is a main part of the photovoltaic assembly 100 and can generate electricity. The cover plate 10 can increase the light transmittance of the photovoltaic assembly 100 and reduce the reflectivity, thereby improving the power generation efficiency of the photovoltaic assembly 100. The encapsulating adhesive film layer 20 mainly fixes the cover plate 10 and the heterojunction cell 30 and connects the cover plate 10 with the heterojunction cell 30 together, so that the photovoltaic assembly 100 forms as an integrated part. The encapsulating adhesive film layer 20 is generally made from a material that is light transmissive, adhesive, resistant to ultraviolet rays and high temperature and that has a low permeability and a high resistivity.

As shown in FIG. 6, the encapsulating adhesive film layer 20 is provided between the heterojunction cell 30 and the cover plate 10. The encapsulating adhesive film layer 20 can connect the cover plate 10 to the heterojunction cell 30 and can fix them together. The encapsulating adhesive film layer 20 is disposed between the cover plate 10 and the heterojunction cell 30. In an actual application of the photovoltaic assembly 100, sunlight will first pass through the cover plate 10, then pass through the encapsulating adhesive film layer 20, and finally arrive at the heterojunction cell 30. The heterojunction cell 30 generates photovoltaic power. A peeling energy value between the heterojunction cell 30 and the encapsulating adhesive film layer 20 is greater than or equal to 200J/m².

It should be noted that, the peeling energy represents a peeling force between two objects. Ggenerally, a greater peeling energy value represents a greater peeling force between two objects and a greater connection strength between the two objects. A smaller peeling energy value represents a smaller peeling force between two objects and a smaller connection strength between the two objects. The peeling energy value between the surface of the heterojunction cell 30 and the encapsulating adhesive film layer 20 is greater than or equal to 200J/m², so that the peeling energy value between the surface of the heterojunction cell 30 and the encapsulating adhesive film layer 20 can be ensured to be in a reliable range. Therefore, the peeling energy value should not be too small. In this way, it can avoid a decrease in the peeling energy between the encapsulating adhesive film layer 20 and the heterojunction cell 30 in the assembling process of the photovoltaic assembly 100, and thus a reduction in the reliability of the connection between the encapsulating adhesive film layer 20 and the heterojunction cell 30.

In some examples of the present disclosure, the peeling energy value between the heterojunction cell 30 and the encapsulating adhesive film layer 20 is greater than or equal to 400J/m². The peeling energy value between the surface of the heterojunction cell and the encapsulating adhesive film layer 20 can be set to be greater than or equal to 400J/m², which further avoids a decrease in the peeling energy between the encapsulating adhesive film layer 20 and the heterojunction cell 30 during the assembly process of the photovoltaic assembly 100 and a reduction in the reliability of the connection between the encapsulating adhesive film layer 20 and the heterojunction cell 30.

In some examples of the present disclosure, as shown in FIG. 7, the heterojunction cell 30 includes: a cell body 31, a transparent conductive film layer 32, and a metal electrode 33. The cell body 31 is a main part of the heterojunction cell 30. The transparent conductive film layer 32 can cooperate with the metal electrode 33, so as to realize the conductive function of the heterojunction cell 30. The transparent conductive film layer 32 is provided on the cell body 31, so that the transparent conductive film layer 32 can be connected with the cell body 31 and can act on the heterojunction cell 30 to play a role of electric conduction. The metal electrode 33 is provided on a surface of the transparent conductive film layer 32 that faces away from the cell body 31. The encapsulating adhesive film layer 20 is provided on a surface of the metal electrode 33 that faces away from the cell body 31, so that the metal electrode 33 can better connect and cooperate with the transparent conductive film layer 32.

In some examples of the present disclosure, as shown in FIGS. 6 and 7, the cover plate 10 includes a first cover plate 11 and a second cover plate 12. The encapsulating adhesive film layer 20 includes a first encapsulating adhesive film layer 21 and a second encapsulating adhesive film layer 22. The first encapsulating adhesive film layer 21 is disposed between the first cover plate 11 and the heterojunction cell 30, and the second encapsulating adhesive film layer 22 is disposed between the second cover plate 12 and the heterojunction cell 30. The peeling energy value between the heterojunction cell 30 and the first encapsulating adhesive film layer 21 is greater than or equal to 200J/m².

In some examples of the present disclosure, with reference to FIG. 6 to FIG. 7, the cell body 31 has a light-receiving surface 310 and a backlighting surface 311. The transparent conductive film layer 32 includes a first transparent conductive film layer 320 and a second transparent conductive film layer 321. The first transparent conductive film layer 320 is disposed on the light-receiving surface 310, and the second transparent conductive film layer 321 is disposed on the backlighting surface 311. The peeling energy value between a surface of the first transparent conductive film layer 320 and the first encapsulating adhesive film layer 21 is greater than or equal to 200J/m²

It can be understood that, the cell body 31 or the heterojunction cell 30 has two surfaces, with the surface that primarily receives sunlight being a front surface, i.e., the light-receiving surface 310, and another surface opposite to the front surface is a surface of the cell body 31 or the heterojunction cell 30 that secondarily receiving sunlight, i.e., the backlighting surface 311. The first transparent conductive film layer 320 may cooperate with the metal electrode 33 disposed on one side of the light-receiving surface 310 to play a role of electric conduction on the light-receiving surface 310 of the cell body 31. The second transparent conductive film layer 321 may cooperate with the metal electrode 33 disposed on one side of the backlighting surface 311 to play a role of electric conduction on the backlighting surface 311 of the cell body 31.

The first transparent conductive film layer 320 is disposed on the first encapsulating adhesive film layer 21. The first encapsulating adhesive film layer 21 is disposed on the first cover plate 11. The first encapsulating adhesive film layer 21 is disposed between the first cover plate 11 and the first transparent conductive film layer 320. The second transparent conductive film layer 321 is disposed on the second encapsulating adhesive film layer 22. The second encapsulating adhesive film layer 22 is disposed on the second cover plate 12. The second encapsulating adhesive film layer 22 is disposed between the second cover plate 12 and the second transparent conductive film layer 321. After the sunlight passes through the first cover plate 11 and the first encapsulating adhesive film layer 21, it reaches the first transparent conductive film layer 320 for electric conduction, and reaches the second encapsulating adhesive film layer 22 through the gap between the heterojunction cells 30. The sunlight passes through the second encapsulating adhesive film layer 22 to reach the second cover plate 12, and is reflected by the second cover plate 12. The reflected sunlight irradiates on the second transparent conductive film layer 321 through the second encapsulating adhesive film layer 22, that is, returns back to the heterojunction cell 30 again, so as to increase the conversion efficiency of the heterojunction cell 30.

In addition, the peeling energy value between the heterojunction cell 30 and the surface of the first transparent conductive film layer 320 and the first encapsulating adhesive film layer 21 is greater than or equal to 200J/m², so that the peeling energy value between the heterojunction cell 30 and the surface of the first transparent conductive film layer 320 and the first encapsulating adhesive film layer 21 can be ensured to be in a reliable range. The peeling energy value should not be too small. In this way, it can avoid a decrease in the peeling energy between the heterojunction cell 30 and the surface of the first encapsulating adhesive film layer 21 and the first transparent conductive film layer 320 during the assembly process of the photovoltaic assembly 100 and thus a reduction in the reliability of the connection between the heterojunction cell 30 and the first encapsulating adhesive film layer 21 and the heterojunction cell 30.

Further, the peeling energy value between a surface of the second transparent conductive film layer 321 and the second encapsulating adhesive film layer 22 is greater than or equal to 200J/m². Similarly, this can ensure that the peeling energy value between the surface of the second transparent conductive film layer 321 and the second encapsulating adhesive film layer 22 is in a reliable range. The peeling energy value should not be too small. Therefore, it can avoid a decrease in the peeling energy between the second encapsulating adhesive film layer 22 and the surface of the second transparent conductive film layer 321 during the assembly process of the photovoltaic assembly 100, and thus a reduction in the reliability of the connection between the second encapsulating adhesive film layer 22 and the heterojunction cell 30.

In some examples of the present disclosure, the transparent conductive film layer 32 is a transparent conductive film layer 32 in which the mass concentration of indium trioxide is greater than 90%. It should be noted that the main components of the transparent conductive film layer 32 are indium trioxide and tin dioxide. Indium trioxide is a new n-type transparent semiconductor functional material with a wide band gap, a smaller resistivity, and higher catalytic activity, and is widely used in the fields of optoelectronics, gas sensors, and catalysts. The mass concentration of indium trioxide in the transparent conductive film layer 32 is greater than 90%, which can make the transparent conductive film layer 32 have better relevant performance and achieve a better transparent and conductive effect. In addition, the surface energy of the transparent conductive film layer 32 can be improved to a certain extent, and the decline degree of the surface energy of the surface of the transparent conductive film layer 32 during the preparation process of the heterojunction cell 30 can be reduced, so that the peeling energy between the encapsulating adhesive film layer 20 and the surface of the transparent conductive film layer 32 can be improved.

Optionally, the transparent conductive film layer 32 is a transparent conductive film layer 32 in which the mass concentration of indium trioxide is greater than 95%. The mass concentration of indium trioxide in the transparent conductive film layer 32 being set to be greater than 95% generates a better relevant performance of the transparent conductive film layer 32 and a better transparent conductive effect, further improves the surface energy of the transparent conductive film layer 32, reduces the decline degree of the surface energy of the electrode fixing surface 34 during the preparation process of the heterojunction cell 30, and enhances the peeling energy between the encapsulating adhesive film layer 20 and the surface of the transparent conductive film layer 32.

In some examples of the present disclosure, referring to FIGS. 6 and 7, the cell body 31 includes a silicon substrate 312 and an amorphous silicon layer 313. The amorphous silicon layer 313 is disposed on a surface of the silicon substrate 312. The transparent conductive film layer 32 is disposed on a surface of the amorphous silicon layer 313. The surface of the silicon substrate 312 is a textured surface, and the textured surface has an average size of less than 2µm. The silicon substrate 312 is made from a material used for production of a heterojunction cell. The amorphous silicon layer 313 is provided on a surface of the silicon substrate 312. The amorphous silicon layer 313 is provided on the light-receiving surface 310 and the backlighting surface 311 of the silicon substrate 312 at the same time, so that both the light-receiving surface 310 and the backlighting surface 311 of the silicon substrate 312 can form the crystalline silicon substrate 312. The surface of the silicon substrate 312 is set as a textured surface, and the textured surface has an average size of less than 2µm. It is to be noted that, the textured surface of this size, compared to a polished surface with the same size, is easier to achieve high surface energy after UV irradiation. Therefore, it can avoid a decrease in the peeling energy between the encapsulating adhesive film layer 20 and the transparent conductive film layer 32, which would otherwise reduce the reliability of the connection between the encapsulating adhesive film layer 20 and the heterojunction cell 30. Of course, the average size of the textured surface is greater than or equal to 1.3µm and less than or equal to 1.7µm. Thereby, the range of the average size of the textured surface is defined, so that the average size of the textured surface is more reasonable, and it is easier for the textured surface to achieve a high surface energy, thereby avoiding a decrease in the peeling energy between the encapsulating adhesive film layer 20 and the transparent conductive film layer 32, which would otherwise reduce the reliability of the connection between the encapsulating adhesive film layer 20 and the heterojunction cell 30.

It should be noted that the size of the textured surface is a Feret diameter of a pyramid. Within a unit area of the light-receiving surface 310 of the silicon substrate 312, a percentage of the number of pyramids with a Feret diameter in a range of 1µm to 1.5µm is 20% to 40%, a percentage of the number of pyramids with a Feret diameter in a range of 1.5µm to 2µm is 20% to 40%. Furthermore, within a unit area of the light-receiving surface 310 of the silicon substrate 312, a percentage of the number of pyramids with a Feret diameter of less than 1µm is no greater than 10%, a percentage of the number of pyramids with a Feret diameter in the range of 2µm to 2.5µm is 5% to 25%, and a percentage of the number of pyramids with a Feret diameter greater than 2.5µm is less than 5%. Preferably, on the light-receiving surface 310 of the silicon substrate 312, the Feret diameter of each pyramid is not greater than 3 µm.

Within a unit area of the backlighting surface 311 of the silicon substrate 312, a percentage of the number of pyramids with a Feret diameter in the range of 1.5µm to 2µm is 10% to 30%, a percentage of the number of pyramids with a Feret diameter in the range of 2µm to 2.5µm is 20% to 40%. Further, within a unit area of the backlighting surface 311 of the silicon substrate 312, a percentage of the number of pyramids with a Feret diameter less than 1µm is no greater than 10%, a percentage of the number of pyramids with a Feret diameter in the range of 1µm to 1.5µm is 10% to 20%, a percentage of the number of pyramids with a Feret diameter in the range of 2.5µm to 3µm is 5% to 20%, and a percentage of the number of pyramids with a Feret diameter greater than 3µm is less than 5%. Preferably, on the backlighting surface 311 of the silicon substrate 312, the Feret diameter of each of the pyramids is not greater than 4µm.

From the above, multiplying the number of pyramids in different diameter ranges by corresponding diameters respectively to obtain a value and then dividing the value by the total number of pyramids can obtain the average size of the textured surface. The average size of the textured surface is greater than or equal to 1.3µm and the average size of the textured surface is less than or equal to 1.7µm.

The following is a detailed description of the test method for the surface energy of the heterojunction cell 30.

Inks with different surface energy values are selected to be respectively applied onto the surface of the heterojunction cell 30 via brush coating. The expansion or contraction of the inks within 5 seconds is observed. If the surface energy of the heterojunction cell 30 is less than or equal to the surface energy value of the ink, the ink does not expand or contract. If the surface energy of the heterojunction cell is greater than the surface energy value of the ink, the ink expands. The upper limit of the surface energy of the test ink is 72mN/m.

Preparation process: the heterojunction cell 30 can be prepared by texturing, chemical vapor deposition (CVD), physical vapor deposition (PVD), screen printing, low-temperature drying, curing, photo-thermal processing.

The heterojunction cell 30 having a high surface energy is realized by post-treatment, mainly by using a certain method to decompose the organic matter adsorbed on the surface of the heterojunction cell 30, including high-temperature treatment, ultraviolet (UV) illumination, plasma (plasma) treatment, and ozone (O₃) oxidation and so on.

The light-receiving surface 310 of the heterojunction cell 30 has an initial surface energy of 34mN/m, and the backlighting surface 311 has a surface energy of 34mN/m.

Post-treatment 1: the light-receiving surface 310 of the heterojunction cell 30 is irradiated by UV with 150W/m² at 60°C for a duration of 12h. The surface energy of the light-receiving surface 310 of the heterojunction cell 30 is enhanced to 48mN/m, and the surface energy of the backlighting surface 311 of the heterojunction cell 30 remains unchanged. The initial peeling energy of the module is 510J/m², which is higher than the peeling energy of the light-receiving surface 310 of the untreated heterojunction cell 30. In particular, after the DH and UV treatments, the peeling energy of the light-receiving surface 310 after the post-treatment 1 can be maintained at 390J/m², which is significantly improved compared to 130J/m² before the treatment. Therefore, it is conducive to improving the reliability of the module outdoors.

Post-treatment 2: the light-receiving surface 310 of the heterojunction cell 30 is irradiated by UV with 150W/m² at 60°C for a duration of 48h, the surface energy of the light-receiving surface 310 of the heterojunction cell 30 is enhanced to 58mN/m, and the surface energy of the backlighting surface 311 of the heterojunction cell 30 remains unchanged. The initial peeling energy of the photovoltaic assembly 100 is 660J/m², which is higher than the peeling energy of the light-receiving surface 310 of the untreated heterojunction cell 30. In particular, after the DH and UV treatments, the peeling energy of the light-receiving surface 310 after the post-treatment 1 can be maintained at 640J/m², which is a significantly improved compared to 130J/m² before the treatment and is substantially the same as the initial peeling energy.

Post-treatment 3: the light-receiving surface 310 of the heterojunction cell 30 is irradiated by UV with 150W/m² at 60°C for a duration of 168h, the surface energy of the light-receiving surface 310 of the heterojunction cell 30 is raised to greater than 72mN/m, and the surface energy of the backlighting surface 311 of the heterojunction cell 30 remains unchanged. The initial peeling energy of the assembly is 660J/m², which is higher than the peeling energy of the light-receiving surface 310 of the untreated heterojunction cell 30. In particular, after the DH and UV treatments, the peeling energy of the light-receiving surface 310 after the post-treatment can rise to 1150J/m². It indicates that the cell chip surface that is adequately treated is bonded to an adhesive film, the bonding can be strengthened under the action of a certain temperature and UV light, which greatly enhances the outdoor reliability of the assembly.

The DH and UV treatments described above refer to continuous aging treatment for 200 hours under UV irradiation of not less than 170W/m² at a temperature of 85°C and a relative humidity of 85%. The UV spectrum shall conform to the description of IEC 61215-2:2016 on UV spectra.

Post-treatment 4: heating at 180°C is performed for 1h, the surface energy of the light-receiving surface 310 of the heterojunction cell 30 is enhanced to 44mN/m, and the surface energy of the backlighting surface 311 is enhanced to 44mN/m.

Post-treatment 5: air plasma, 50W, 30s, the surface energy of the light-receiving surface 310 of the heterojunction cell 30 is enhanced to 40mN/m, and the surface energy of the backlighting surface 311 of the heterojunction cell 30 is enhanced to 40mN/m.

**Table 3 Improvement of surface energy of the light-receiving surface 310 of the heterojunction cell 30 caused by different post-treatments**

| Sample | The surface energy of the light-receiving surface 310 of the heterojunction cell 30 (mN/m) | The surface energy of the backlighting surface 311 of the heterojunction cell 30 (mN/m) | Peeling energy between the light-receiving surface 310 of the heterojunction cell 30 and EVA (J/m²) | After the D H and UV treatments, peeling energy between the light-receiving surface 310 of the heterojunction cell 30 and EVA (J/m²) |
|---|---|---|---|---|
| heterojunction cell 30 | 34 | 34 | 430 | 130 |
| heterojunction cell 30 and post-treatment 1 | 48 | 34 | 510 | 390 |
| heterojunction cell 30 and post-treatment 2 | 58 | 34 | 660 | 640 |
| heterojunction cell 30 and post-treatment 3 | greater than 72 | 34 | 710 | 1150 |
| heterojunction cell 30 and post-treatment 4 | 44 | 44 | / | / |
| heterojunction cell 30 and post-treatment 5 | 40 | 40 | / | / |
| heterojunction cell 30 and post-treatment 2 | 58 | 34 | peeling capability with POE 570 | peeling capability with POE 500 |

As can be seen from Table 3 above, after post-treatment 3 on the heterojunction cell 30, it can better enhance the surface energy of the light-receiving surface 310 of the heterojunction cell 30, so as to better improve the peeling energy between the light-receiving surface 310 of the heterojunction cell 30 and the EVA (ethylene-vinyl acetate copolymer) or POE (polyethylene-octene elastomer), which is the peeling energy between the encapsulating adhesive film layer 20 and the transparent conductive film layer 32, thereby enhancing the connection reliability of the encapsulating adhesive film layer 20 and the heterojunction cell 30.

As shown in FIG. 7, a heterojunction cell 30 according to an embodiment in a third aspect of the present disclosure includes a cell body 31, a transparent conductive film layer 32, and a metal electrode 33. The cell body 31 is a main part of the heterojunction cell 30, the transparent conductive film layer 32 can be combined with the metal electrode 33, so that the conductive function of the heterojunction cell 30 can be realized. The transparent conductive film layer 32 is disposed on the cell body 31, so that the transparent conductive film layer 32 can be connected with the cell body 31 and can act on the heterojunction cell 30 to play a role of electronic conduction. A surface at one side of the transparent conductive film layer 32 that faces away from the cell body 31 is an electrode fixing surface 34, the electrode fixing surface 34 can be used to fix the metal electrode 33. The metal electrode 33 can be provided on the electrode fixing surface 34, so that the metal electrode 33 can be better connected with the transparent conductive film layer 32 to better cooperate with the transparent conductive film layer 32.

It should be noted that the surface energy refers to a non-volume work done to an object that is needed for reversibly increasing a surface area of the object under the condition of constant temperature, constant pressure, and constant composition. The surface energy value of the electrode fixing surface 34 is greater than or equal to 40mN/m, which can ensure that the surface energy of the electrode fixing surface 34 is maintained in a reliable range. In this way, in the preparation process of the heterojunction cell 30, it can avoid that the surface energy of the electrode fixing surface 34 decreases and thus avoid a decrease in the peeling energy between the encapsulating adhesive film layer 20 and the transparent conductive film layer 32, so as to enhance the reliability of the connection between the encapsulating adhesive film layer 20 and the heterojunction cell 30. The surface energy value of the electrode fixing surface 34 is greater than or equal to 40mN/m and the surface energy value of the electrode fixing surface 34 is less than or equal to 80mN/m. As described above, the surface energy value of the electrode fixing surface 34 is greater than or equal to 40mN/m, so that the surface energy of the electrode fixing surface 34 remains in a reliable range, avoiding a decrease in the peel energy of the encapsulating adhesive film layer 20 and the transparent conductive film layer 32 and thus a reduction in the reliability of the connection between the encapsulating adhesive film layer 20 and the heterojunction cell 30.

Further, the surface energy value of the electrode fixing surface 34 is greater than or equal to 60mN/m and the surface energy value of the electrode fixing surface 34 is less than or equal to 80mN/m. Of course, the surface energy value of the electrode fixing surface 34 may be greater than or equal to 60mN/m, and preferably the surface energy value of the electrode fixing surface 34 is greater than or equal to 70mN/m. In this way, while ensuring that the surface energy is stabilized, the connection reliability of the encapsulating adhesive film layer 20 and the heterojunction cell 30 can be improved.

In some examples of the present disclosure, as shown in FIG. 6, the cell body 31 has a light-receiving surface 310 and a backlighting surface 311. The transparent conductive film layer 32 includes a first transparent conductive film layer 320 and a second transparent conductive film layer 321. The first transparent conductive film layer 320 is disposed on the light-receiving surface 310, and the second transparent conductive film layer 321 is disposed on the backlighting surface 311. A surface at one side of the first transparent conductive film layer 320 that faces away from the light-receiving surface 310 is a first electrode fixing surface 341, and a surface at one side of the second transparent conductive film layer 321 that faces away from the backlighting surface 311 is a second electrode fixing surface 342. The first electrode fixing surface has a surface energy value greater than or equal to 40mN/m.

It can be understood that, the cell body 31 or the heterojunction cell 30 has two surfaces, with the surface that primarily receives sunlight being a front surface, i.e., the light-receiving surface 310, and another surface opposite to the front surface is a surface of the cell body 31 or the heterojunction cell 30 that secondarily receiving sunlight, i.e., the backlighting surface 311. The first transparent conductive film layer 320 may cooperate with the metal electrode 33 disposed on one side of the light-receiving surface 310 to play a role of electric conduction on the light-receiving surface 310 of the cell body 31. The second transparent conductive film layer 321 may cooperate with the metal electrode 33 disposed on one side of the backlighting surface 311 to play a role of electric conduction on the backlighting surface 311 of the cell body 31. The surface energy value of the first electrode fixing surface 341 is greater than or equal to 40mN/m, so that the surface energy of the first electrode fixing surface 341 can remain in a reliable range, avoiding a decrease in the peeling energy between the first transparent conductive film layer 320 and the encapsulating adhesive film layer 20 disposed on the side of the light-receiving surface 310, and a decrease in the reliability of the connection between the heterojunction cell 30 and the encapsulating adhesive film layer 20 disposed on the side of the light-receiving surface 310.

In addition, as shown in FIG. 6, the surface at one side of the second transparent conductive film layer 321 that faces away from the backlighting surface 311 is a second electrode fixing surface 342, and the second electrode fixing surface has a surface energy value greater than or equal to 40mN/m. Similarly, the surface energy of the second electrode fixing surface 342 can be kept in a reliable range, avoiding a decrease in the peeling energy between the second transparent conductive film layer 321 and the encapsulating adhesive film layer 20 disposed on the side of the backlighting surface 311, and a decrease in the reliability of the connection between the heterojunction cell 30 and the encapsulating adhesive film layer 20 disposed on the side of the backlighting surface 311.

In an optional example of the present disclosure, the transparent conductive film layer 32 is a transparent conductive film layer 32 in which the mass concentration of indium trioxide is greater than 90%. It should be noted that the main components of the transparent conductive film layer 32 are indium trioxide and tin dioxide. Indium trioxide is a new n-type transparent semiconductor functional material with a wide band gap, a smaller resistivity, and higher catalytic activity, and is widely used in the fields of optoelectronics, gas sensors, and catalysts. The mass concentration of indium trioxide in the transparent conductive film layer 32 is greater than 90%, which can make the transparent conductive film layer 32 have better relevant performance and achieve a better transparent and conductive effect. In addition, the surface energy of the transparent conductive film layer 32 can be improved to a certain extent, and reduce the decline degree of the surface energy of the electrode fixing surface 34 during the preparation process of the heterojunction cell 30.

Optionally, the transparent conductive film layer 32 is a transparent conductive film layer 32 in which the mass concentration of indium trioxide is greater than 95%. The mass concentration of indium trioxide in the transparent conductive film layer 32 being set to be greater than 95% generates a better relevant performance of the transparent conductive film layer 32 and a better transparent conductive effect, further improves the surface energy of the transparent conductive film layer 32, reduces the decline degree of the surface energy of the electrode fixing surface 34 during the preparation process of the heterojunction cell 30.

In some examples of the present disclosure, the cell body 31 includes a silicon substrate 312 and an amorphous silicon layer 313. The amorphous silicon layer 313 is disposed on the silicon substrate 312. The transparent conductive film layer 32 is disposed on the amorphous silicon layer 313, the surface of the silicon substrate 312 is a textured surface, and the average size of the textured surface is less than 2µm. The silicon substrate 312 is made from a material used for production of a heterojunction cell. The amorphous silicon layer 313 is provided on the silicon substrate 312. The amorphous silicon layer 313 is provided on the light-receiving surface 310 and the backlighting surface 311 of the silicon substrate 312 at the same time, so that both the light-receiving surface 310 and the backlighting surface 311 of the silicon substrate 312 can form the crystalline silicon substrate 312. The surface of the silicon substrate 312 is set as a textured surface, and the average size of the textured surface is less than 2µm. It is to be noted that, the textured surface of this size, compared to a polished surface with the same size, is easier to achieve high surface energy after UV irradiation. Therefore, it can avoid a decrease in the peeling energy between the encapsulating adhesive film layer 20 and the transparent conductive film layer 32, which would otherwise reduce the reliability of the connection between the encapsulating adhesive film layer 20 and the heterojunction cell 30.

In addition, the average size of the textured surface is greater than or equal to 1.3µm and less than or equal to 1.7µm. Thereby, the range of the average size of the textured surface is defined, so that the average size of the textured surface is more reasonable, and it is easier for the textured surface to achieve a high surface energy, thereby avoiding a decrease in the peeling energy between the encapsulating adhesive film layer 20 and the transparent conductive film layer 32, which would otherwise reduce the reliability of the connection between the encapsulating adhesive film layer 20 and the heterojunction cell 30.

It should be noted that the size of the textured surface is a Feret diameter of a pyramid. Within a unit area of the light-receiving surface 310 of the silicon substrate 312, a percentage of the number of pyramids with a Feret diameter in a range of 1µm to 1.5µm is 20% to 40%, a percentage of the number of pyramids with a Feret diameter in a range of 1.5µm to 2µm is 20% to 40%. Furthermore, within a unit area of the light-receiving surface 310 of the silicon substrate 312, a percentage of the number of pyramids with a Feret diameter of less than 1µm is no greater than 10%, a percentage of the number of pyramids with a Feret diameter in the range of 2µm to 2.5µm is 5% to 25%, and a percentage of the number of pyramids with a Feret diameter greater than 2.5µm is less than 5%. Preferably, on the receiving surface 310 of the silicon substrate 312, the Feret diameter of each of the pyramids is not greater than 3µm.

Within a unit area of the backlighting surface 311 of the silicon substrate 312, a percentage of the number of pyramids with a Feret diameter in the range of 1.5µm to 2µm is 10% to 30%, a percentage of the number of pyramids with a Feret diameter in the range of 2µm to 2.5µm is 20% to 40%. Further, within a unit area of the backlighting surface 311 of the silicon substrate 312, a percentage of the number of pyramids with a Feret diameter less than 1µm is no greater than 10%, a percentage of the number of pyramids with a Feret diameter in the range of 1µm to 1.5µm is 10% to 20%, a percentage of the number of pyramids with a Feret diameter in the range of 2.5µm to 3µm is 5% to 20%, and a percentage of the number of pyramids with a Feret diameter greater than 3µm is less than 5%. Preferably, on the backlighting surface 311 of the silicon substrate 312, the Feret diameter of each of the pyramids is not greater than 4µm.

From the above, multiplying the number of pyramids in different diameter ranges by corresponding diameters respectively to obtain a value and then dividing the value by the total number of pyramids can obtain the average size of the textured surface. The average size of the textured surface is greater than or equal to 1.3µm and the average size of the textured surface is less than or equal to 1.7µm.

The following is a detailed description of the test method for the surface energy of the heterojunction cell 30.

Inks with different surface energy values are selected to be respectively applied onto the surface of the heterojunction cell 30 via brush coating. The expansion or contraction of the inks within 5 seconds is observed. If the surface energy of the heterojunction cell 30 is less than or equal to the surface energy value of the ink, the ink does not expand or contract. If the surface energy of the heterojunction cell is greater than the surface energy value of the ink, the ink expands. The upper limit of the surface energy of the text ink is 72mN/m.

Preparation process: the heterojunction cell 30 can be prepared by texturing, chemical vapor deposition (CVD), physical vapor deposition (PVD), screen printing, low-temperature drying, curing, and photo-thermal processing.

The heterojunction cell 30 having a high surface energy is realized by post-treatment, mainly by using a certain method to decompose the organic matter adsorbed on the surface of the heterojunction cell 30, including high-temperature treatment, ultraviolet (UV) illumination, plasma (plasma) treatment, and ozone (O₃) oxidation and so on.

The light-receiving surface 310 of the heterojunction cell 30 has an initial surface energy of 34mN/m, and the backlighting surface 311 has a surface energy of 34mN/m.

Post-treatment 1: the light-receiving surface 310 of the heterojunction cell 30 is irradiated by UV with 150W/m² at 60°C for a duration of 12h. The surface energy of the light-receiving surface 310 of the heterojunction cell 30 is enhanced to 48mN/m, and the surface energy of the backlighting surface 311 of the heterojunction cell 30 remains unchanged.

Post-treatment 2: the light-receiving surface 310 of the heterojunction cell 30 is irradiated by UV with 150W/m² at 60°C for a duration of 48h, the surface energy of the light-receiving surface 310 of the heterojunction cell 30 is enhanced to 58mN/m, and the surface energy of the backlighting surface 311 of the heterojunction cell 30 remains unchanged.

Post-treatment 3: the light-receiving surface 310 of the heterojunction cell 30 is irradiated by UV with 150W/m² at 60°C for a duration of 168h, the surface energy of the light-receiving surface 310 of the heterojunction cell 30 is raised to greater than 72mN/m, and the surface energy of the backlighting surface 311 of the heterojunction cell 30 remains unchanged.

Post-treatment 4: heating at 180°C is performed for 1h, the surface energy of the light-receiving surface 310 of the heterojunction cell 30 is enhanced to 44mN/m, and the surface energy of the backlighting surface 311 is enhanced to 44mN/m.

Post-treatment 5: air plasma, 50W, 30s, the surface energy of the light-receiving surface 310 of the heterojunction cell 30 is enhanced to 40mN/m, and the surface energy of the backlighting surface 311 of the heterojunction cell 30 is enhanced to 40mN/m.

**Table 4 Improvement of surface energy of the light-receiving surface 310 of the heterojunction cell 30 caused by different post-treatments**

| Sample | The surface energy of the light-receiving surface 310 of the heterojunction cell 30 (mN/m) | The surface energy of the backlighting surface 311 of the heterojunction cell 30 (mN/m) | The peeling energy (J/m²) between the light-receiving surface 310 of the heterojunction cell 30 and EVA |
|---|---|---|---|
| heterojunction cell 30 | 34 | 34 | 430 |
| heterojunction cell 30 and post-treatment 1 | 48 | 34 | 510 |
| heterojunction cell 30 and post-treatment 2 | 58 | 34 | 660 |
| heterojunction cell 30 and post-treatment 3 | greater than 72 | 34 | 710 |
| heterojunction cell 30 and post-treatment 4 | 44 | 44 | / |
| heterojunction cell 30 and post-treatment 5 | 40 | 40 | / |

As can be seen from Table 4 above, after post-treatment 3 on the heterojunction cell 30, it can better enhance the surface energy of the light-receiving surface 310 of the heterojunction cell 30, so as to better improve the peeling energy between the light-receiving surface 310 of the heterojunction cell 30 and the EVA (ethylene-vinyl acetate copolymer), which is the peeling energy between the encapsulating adhesive film layer 20 and the transparent conductive film layer 32, thereby enhancing the connection reliability of the encapsulating adhesive film layer 20 and the heterojunction cell 30.

In the description of the present disclosure, it should be understood that orientations or positional relationships indicated by terms "center", "longitudinal", "transverse", "length", "width", "thickness", "upper", "lower", "front", "rear", "left", "right", "vertical", "horizontal", "top", "bottom", "inner", "outer", "clockwise", "anticlockwise", "axial", "radial" and "circumferential" are based on orientations or positional relationships shown in the drawings, are only for ease of description of the present disclosure and simplification of the description, rather than indicating or implying that an indicated device or element must have a particular orientation, be constructed and operated in a particular orientation, and therefore cannot be construed as limiting the present disclosure.

In the description of the present disclosure, "first feature" and "second feature" may include one or more such features. In the description of the present disclosure, "multiple" means two or more. In the description of the present disclosure, the first feature being "above" or "below" the second feature may include the first and second features being in direct contact, or the first and second features being in indirect contact via another feature between them. In the description of the present disclosure, the first feature being "above" or "on top of" the second feature indicates the first feature being directly above or diagonally above the second feature, or merely indicates that the first feature is horizontally higher than the second feature.

In the description of the present disclosure, the description with reference to the terms "one embodiment", "some embodiments", "exemplary embodiments", "example", "specific example", or "some examples", etc., means that specific features, structures, materials, or characteristics described in conjunction with the embodiment(s) or example(s) are included in at least one embodiment or example of the present disclosure. In the present disclosure, any illustrative reference to the above terms does not necessarily refer to the same embodiment(s) or example(s).

Although the embodiments of the present disclosure have been shown and described above, it can be appreciated by those of ordinary skill in the art that various changes, modifications, alternatives and variants can be made to the above embodiments without departing from the principle and the spirit of the present disclosure. The scope of the disclosure is defined by claims and equivalents thereof.

## Claims

1. A method for preparing a photovoltaic assembly, comprising:
preparing a plurality of cell chips;
forming a cell string, comprising connecting the plurality of cell chips by an electrical connector to form the cell string; and
irradiating the plurality of cell chips with light, comprising irradiating the plurality of cell chips with light having a wavelength in a range of 200nm to 500 nm.

2. The method for preparing the photovoltaic assembly according to claim 1, further comprising: before said forming the cell string,
irradiating the plurality of cell chips using light having a wavelength in a range of 200nm to 500 nm.

3. The method for preparing the photovoltaic assembly according to claim 2, wherein said preparing the plurality of cell chips comprises: performing cutting using a slicing machine to form the plurality of cell chips;
said irradiating the plurality of cell chips with light comprises: irradiating the plurality of cell chips with light having a wavelength in the range of 200nm to 500 nm on a transfer track located behind the slicing machine; and/or
the method further comprises: after said preparing the plurality of cell chips and before said irradiating the plurality of cell chips with light, or after said irradiating the plurality of cell chips with light and before said forming the cell string,
stacking the plurality of cell chips up;
loading the plurality of cell chips that are stacked up onto a series welding machine.

4. The method for preparing the photovoltaic assembly according to claim 2 or 3, wherein said irradiating the plurality of cell chips with light further comprises: after said forming the cell string,
irradiating the cell string with light having a wavelength in the range of 200nm to 500 nm.

5. The method for preparing the photovoltaic assembly according to claim 1, further comprising: after said forming the cell string,
irradiating the cell string with light having a wavelength in a range of 200nm to 500 nm.

6. The method for preparing the photovoltaic assembly according to any of claims 1 to 5, wherein said irradiating the plurality of cell chips with light comprises:
irradiating the plurality of the cell chips or the cell string using UV light.

7. The method for preparing the photovoltaic assembly according to claim 6, wherein said irradiating the plurality of cell chips with light comprises:
irradiating the plurality of cell chips or the cell string using a UV light combination; or
irradiating the plurality of cell chips or the cell string using UVC of different wavelengths.

8. The method for preparing the photovoltaic assembly according to claim 7, wherein said irradiating the plurality of cell chips with light comprises:
irradiating the plurality of cell chips or the cell string with UVC that has a first wavelength and a radiation intensity in a range of 5W/m² to 30W/m² and UVC that has a second wavelength and a radiation intensity in a range of 100W/m² to 500W/m², the first wavelength is less than the second wavelength.

9. The method for preparing the photovoltaic assembly according to claim 8, wherein in said irradiating the plurality of cell chips with light,
an irradiation duration is t, t satisfying: 1min≤t≤20min; and/or
an ambient temperature is T, T satisfying: 20°C ≤ T ≤ 120°C.

10. A photovoltaic assembly prepared using the method for preparing the photovoltaic assembly according to any one of claims 1 to 9.

11. The photovoltaic assembly according to claim 10, comprising:
a cover plate;
an encapsulating adhesive film layer; and
a heterojunction cell, wherein the encapsulating adhesive film layer is provided between the heterojunction cell and the cover plate, and a peeling energy value between the heterojunction cell and the encapsulating adhesive film layer is greater than or equal to 200 J/m².

12. The photovoltaic assembly according to claim 11, wherein the peeling energy value between the heterojunction cell and the encapsulating adhesive film layer is greater than or equal to 400 J/m².

13. The photovoltaic assembly according to claim 11 or 12, wherein the heterojunction cell comprises:
a cell body;
a transparent conductive film layer provided on the cell body; and
a metal electrode, the metal electrode being provided on a surface of the transparent conductive film layer that faces away from the cell body, and the encapsulating adhesive film layer being provided on a surface of the metal electrode that faces away from the cell body.

14. The photovoltaic assembly according to claim 13, wherein the cover plate comprises
a first cover plate and a second cover plate;
the encapsulating adhesive film layer comprises a first encapsulating adhesive film layer and a second encapsulating adhesive film layer, the first encapsulating adhesive film layer is disposed between the first cover plate and the heterojunction cell, and the second encapsulating adhesive film layer is disposed between the second cover plate and the heterojunction cell; and
the peeling energy value between the heterojunction cell and the first encapsulating adhesive film layer is greater than or equal to 200 J/m².

15. The photovoltaic assembly according to claim 14, wherein the cell body has a light-receiving surface and a backlighting surface, the transparent conductive film layer comprises a first transparent conductive film layer and a second transparent conductive film layer, the first transparent conductive film layer is disposed on the light-receiving surface, and the second transparent conductive film layer is disposed on the backlighting surface,
the peeling energy value between a surface of the first transparent conductive film layer and the first encapsulating adhesive film layer is greater than or equal to 200 J/m²; and/or
the peeling energy value between a surface of the second transparent conductive film layer and the second encapsulating adhesive film layer is greater than or equal to 200 J/m².

16. The photovoltaic assembly according to any of claims 13 to 15, wherein the cell body comprises a silicon substrate and an amorphous silicon layer, the amorphous silicon layer is disposed on a surface of the silicon substrate, the transparent conductive film layer is disposed on a surface of the amorphous silicon layer, the surface of the silicon substrate is a textured surface, and the textured surface has an average size of less than 2µm.

17. A heterojunction cell comprising:
a cell body;
a transparent conductive film layer disposed on the cell body, a surface at one side of the transparent conductive film layer that faces away from the cell body is an electrode fixing surface, and the electrode fixing surface has a surface energy value that is greater than or equal to 40 mN/m and that is less than or equal to 80 mN/m; and
a metal electrode provided on the electrode fixing surface.

18. The heterojunction cell according to claim 17, wherein the cell body has a light-receiving surface and a backlighting surface, the transparent conductive film layer comprises a first transparent conductive film layer and a second transparent conductive film layer, the first transparent conductive film layer is disposed on the light-receiving surface, and the second transparent conductive film layer is disposed on the backlighting surface, a surface at one side of the first transparent conductive film layer that faces away from the light-receiving surface is a first electrode fixing surface, and a surface at one side of the second transparent conductive film layer that faces away from the backlighting surface is a second electrode fixing surface,
the first electrode fixing surface has a surface energy value greater than or equal to 40 mN/m; and/or
the second electrode fixing surface has a surface energy value greater than or equal to 40mN/m.
